# EUROPEAN PATENT APPLICATION

(11) **EP 0 840 132 A2**
(43) Date of publication of application: **06.05.1998**
(21) Application number: 97119298.4
(22) Date of filing: 05.11.1997
(51) Int. Cl.: G01R 19/00

(54) **A device for detecting and indicating potential differences between two bodies**

(30) Priority: 05.11.1996 IT TO960894
(71) Applicant: FIAT AUTO S.p.A., 10135 Torino (IT)
(72) Inventor: Andronaco, Carmelo, 10040 Volvera (Torino) (IT); Collinucci, Luigi, 10137 Torini (IT); Maberto, Achille, 10051 Avigliana (Torino) (IT)
(74) Representative: Quinterno, Giuseppe

(57) **Abstract**

The device (10) comprises an insulating glove (13) having on its palm face (15) an electrically conductive cladding (16) connected to one input (18) of a voltage measuring device (12) and an electrical terminal (26; 16) connected to the other input (19) of the measuring device (12) and intended to be put into contact with one of the said bodies (A, 32) the potential difference between which it is desired to detect.

The measuring device (12) is fixed to the glove (13), preferably on the back outer surface (17).

## Description

The present invention relates to a device for the detection and indication of potential difference between two bodies, including a measuring device operable to provide electrical signals indicative of the potential difference or voltage between two of its input terminals each intended to be connected to one of the said bodies.

The device according to the invention is characterised by the fact that it comprises:
a glove of electrically insulating material the palm of which is provided with an outer cladding of electrically conductive material connected to one input of the said measuring device, and
an electrical terminal connected to the other input of the measuring device and intended to be put into contact with one of the said bodies;
the measuring device being fixed to the glove, preferably on the outer face of the back, in such a way that when the conductive cladding of the palm of the glove worn by a user is put in contact with one of the said bodies whilst the said electrical terminal is in contact with the other body, the measuring device is able to detect and to provide a signal indicative of the potential difference between the said bodies.

In a first embodiment, intended in particular to allow the detection and indication of the potential difference between an object and the body of a user, the said electrical terminal comprises an electrode conveniently formed as an arm band which can be connected to the wrist of the user adjacent to the said glove.

In another embodiment, intended in particular to allow detection of the potential difference between two bodies or objects, the device includes a second glove for the user's other hand, the said second glove having at least one electrically conductive outer surface portion, preferably in its palm face, connected to the said other input of the measuring device by means of an insulated flexible conductor.

Conveniently, these gloves can be incorporated in a garment such as a jacket or the like, intended to be worn by the user, and into which the said insulated flexible conductor is incorporated.

The device according to the invention makes it possible easily to detect and indicate potential differences due for example to the accumulation of electrostatic charges on an object such as a part of a machine or an installation.

Further characteristics and advantages of the invention will become apparent from the following detailed description with reference to the attached drawings, provided purely by way of non-limitative example, in which:
Figure 1 shows a first embodiment of a device according to the invention, including a glove seen substantially in plan view from the back;
Figure 2 is a plan view of the device according to Figure 1, with the glove seen from the palm;
Figure 3 shows a second embodiment of a device according to the invention;
Figures 4 and 5 are respectively front and rear views of a garment incorporating a device according to the invention;
Figure 6 is a block circuit diagram of a device according to the invention; and
Figure 7 is a more detailed circuit diagram of an embodiment of a device according to the invention.

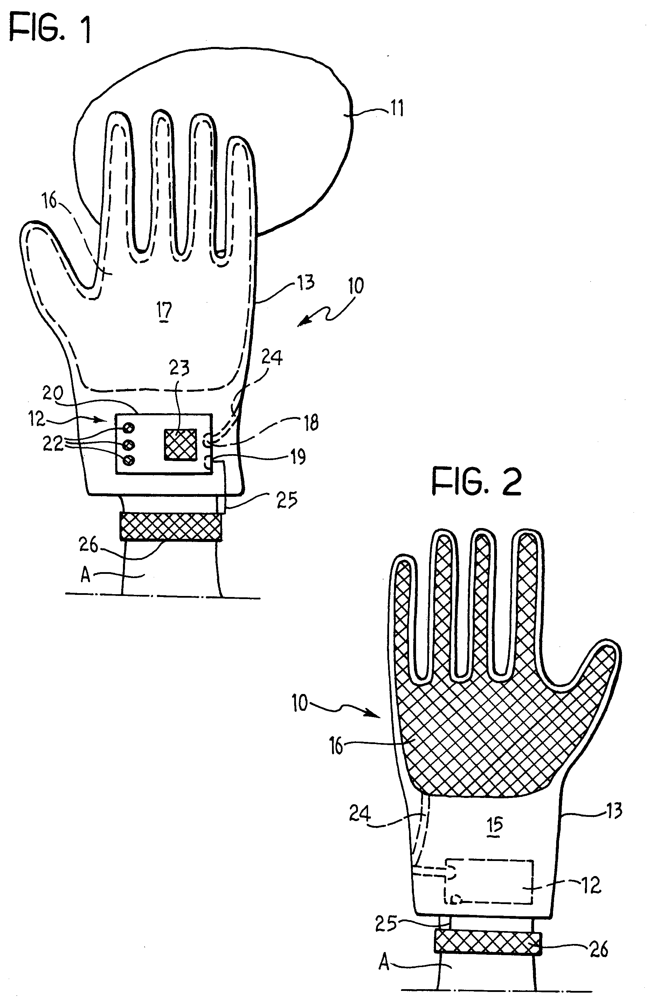

In Figures 1 and 2 a device according to the invention, usable to detect the potential difference between an object 11, such as a part of a machine or installation, and the body of an operator, is generally indicated 10.

The device 10 comprises a glove 13 of electrically insulating material provided, in its palm face 15 (Figure 2) with an outer cladding 16 of electrically conductive material.

On the outer face of the back 17 (Figure 1) of the glove is fixed a measuring device generally indicated 12. This measuring device is able to measure and to provide electrical signals indicative of the potential difference or voltage between its two input terminals 18 and 19. The input terminal 18 of this device is connected to the conductive cladding 16 on the palm of the glove by means of an insulated conductor 24.

The other input 19 of the measuring device 12 is connected by means of a conductor 25 to an electrode 26 formed for example as an arm band which can be connected to the wrist or to the arm A of the user adjacent to the glove 13.

In the exemplary embodiment illustrated the measuring device 12 carries three illuminable optical indicators 22, and an acoustic alarm device 23 constituted for example by a buzzer. These devices 22 and 23 are carried by the casing 20 of the measuring device 12, in particular in such a way that the illuminable indicators 22 are immediately visible by the user.

The device shown in Figure 1 and 2 makes it possible to detect the potential differences between the body A of the user and an object 11 in contact with the conductive cladding 16 on the palm of the glove. Conveniently, as will be described better hereinbelow, the measuring device 12 includes comparison circuits able to compare a signal indicative of the detected potential difference with a plurality of predetermined thresholds such that, when one of them is exceeded, a different illuminable indicator device 22 is illuminated. These illuminable indicators can include for example a green lamp, a yellow lamp and a red lamp intended to be activated for example when the potential difference detected is less than 100 mV or lies between 100mV and 3V, or is greater than 3V. The acoustic device 23 can be activated by the comparison circuits for example when the highest comparison threshold is exceeded.

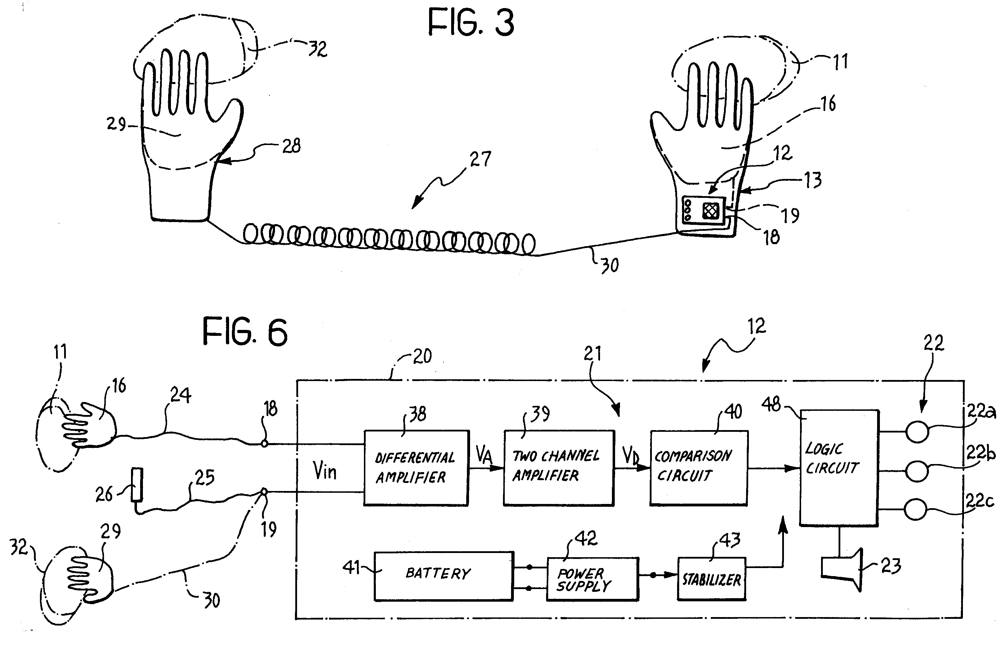

In Figure 3 is shown a second embodiment of a device according to the invention intended to allow detection and indication of potential differences between two objects, indicated in this figure as 11 and 32.

The device of Figure 3 comprises a glove 13 similar to that described above with reference to Figures 1 and 2, provided on the palm with an electrically conductive cladding 16 and on the back with a measurement device 12 of the type described above.

In the embodiment of Figure 3 the input 18 of the measuring device 12 is connected by means of an insulated conductor 30 to a second glove 28 for the user's other hand. The glove 28 is also made, for example, of electrically insulating material and is provided on its palm region with an outer electrically conductive cladding indicated 29, intended to be brought into contact with the body 32.

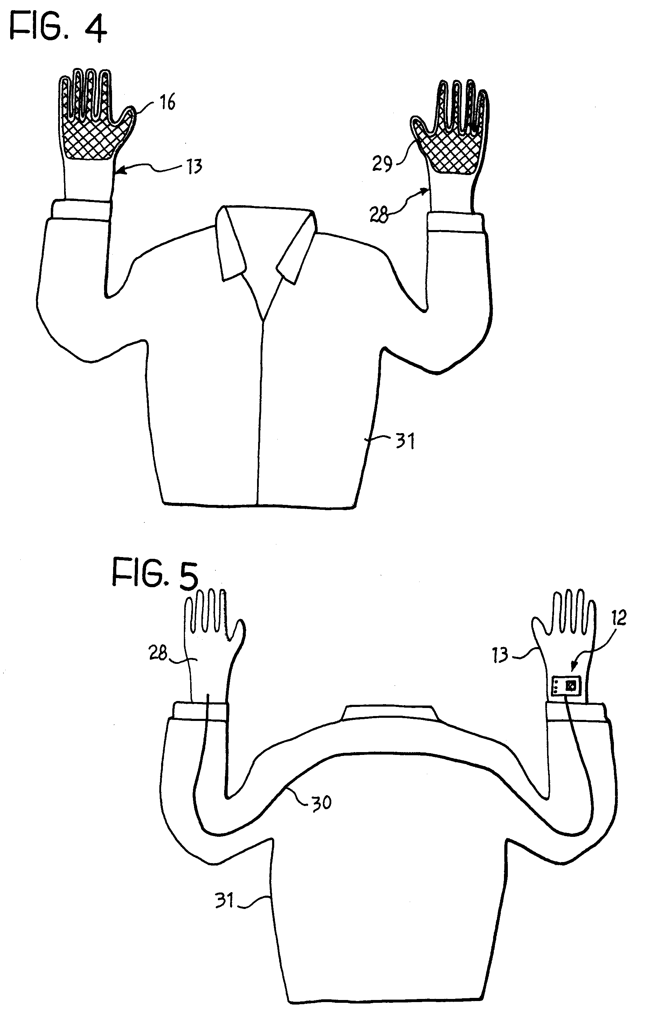

As is shown in Figure 4 and 5, the gloves 13 and 28 of the device according to Figure 3 can constitute an integral part of a garment 31 in the form of a jacket or the like intended to be worn by the user. In this case the connection conductor 30 is conveniently incorporated into the garment 31, for example, in the manner shown in Figure 5.

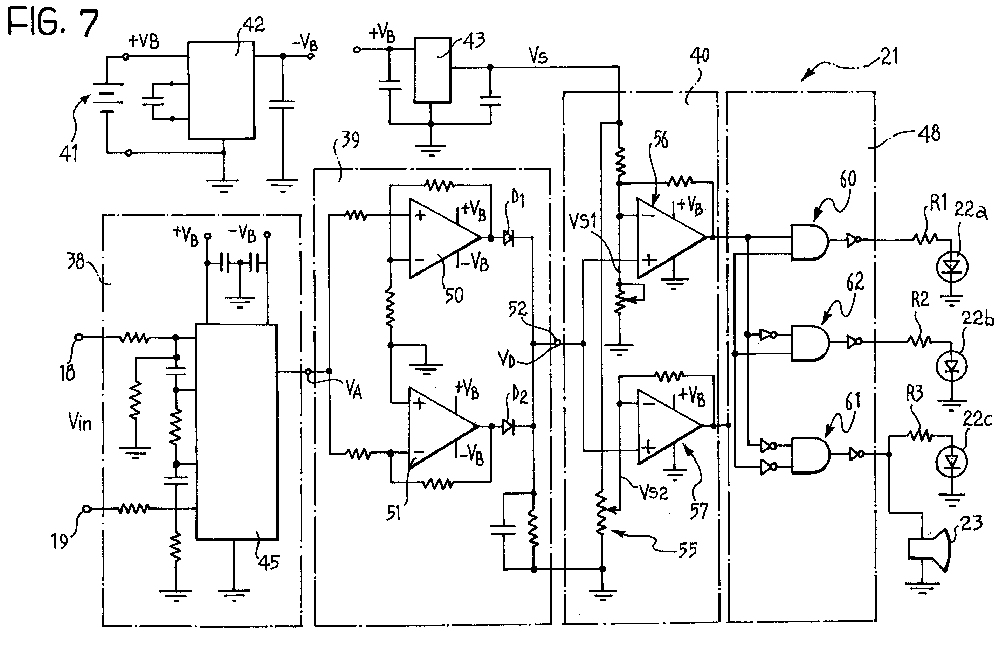

An embodiment of the measurement and indicator device 12 will now be described with reference to the diagrams of Figures 6 and 7.

This device comprises a power supply circuit 42 the input of which is connected to a supply battery 41 and the output of which is coupled to the input of a voltage stabiliser 43. The output of this latter is connected to the supply terminals of various circuits of the device 12.

This device comprises a differential amplifier 38 the inputs 18 and 19 of which represent the input of the entire device and are connected to the electrically conductive cladding 16 of the glove 13 and, respectively, to the electrode 26 or to the electrically conductive cladding 29 of the glove 28.

The differential amplifier 38 has a high input impedance.

At the output of this differential amplifier there is available, in operation, a voltage V_{A} which is positive or negative depending on whether the electric potential at the input 18 is higher or lower than the electric potential at the input 19.

As is shown in the diagram of Figure 7, the differential amplifier 38 can be formed by example by utilising an integrated circuit 45 such as for example an AD620 circuit, and associated resistors and capacitors connected to its terminals in a configuration known per se.

The output of the differential amplifier 38 is connected to the input of an amplifier stage 39 having two channels one comprising a non-inverting amplifier 50 and the other an inverting amplifier 51. The outputs of these amplifiers are connected in an OR configuration to an output terminal 52 via two diodes indicated D1 and D2. With this arrangement the amplifier 50 amplifies the signal V_{A} when it is positive with respect to ground whilst the signal is, on the other hand, amplified by the amplifier 51 when it is negative with respect to ground.

At the output 52 of the amplifier stage 39 there is thus, in any event, a positive signal with respect to ground which is applied to the input of a comparison circuit generally indicated 40.

In the embodiment illustrated in Figure 7 the comparison circuit 40 includes two threshold comparator circuits 56 and 57 which compare the signal V_{D} coming from the amplifier 39 with respective reference voltages VS1 and VS2. The outputs of the threshold comparators 56 and 57 are connected to the inputs of a logic circuit 48.

In the embodiment according to Figure 7 the logic circuit 48 includes three NAND gates 60, 61 and 62 the inputs of which are connected to the outputs of the threshold comparators 56 and 57 directly or via inverters in the manner illustrated in this figure.

The outputs of the logic circuit 48 are connected by means of resistors R1, R2 and R3 to respective light-emitting diodes 22a, 22b and 22c operable to emit, for example, green, yellow or red light respectively.

In the embodiment illustrated the acoustic indicator 23 is essentially connected in parallel to the light-emitting diode 22c.

With the circuit configuration described above the diode 22a is activated when the potential difference between the input terminals 18 and 19 of the measuring device is for example less than 100mV, whilst the diode 22b lights up when this potential difference lies for example between 100mV and 3V, and finally the diode 22c and the acoustic indictor 23 are activated when this potential difference is greater than 3V.

Naturally, the principle of the invention remaining the same, the embodiments and details of construction can be widely varied with respect to has been described and illustrated purely by way of non-limitative example, without by this departing from the ambit of the present invention as defined in the attached claims.

## Claims

1. A device (10) for the detection and indication of potential differences between two bodies (11; A; 32), including a measurement device 12 able to provide electrical signals indicative of the potential difference or voltage between its input terminals (18, 19) each intended to be connected to one of the said bodies; the device being characterised by the fact that it comprises
a glove (13) of electrically insulating material provided on its palm (15) with an outer cladding (16) of electrically conductive material connected to one input (18) of the said measuring device (12), and
an electrical terminal (26; 16) connected to the other input (19) of the said measuring device (12) and intended to be put into contact with one of the said two bodies (A, 32);
the measuring device (12) being fixed to the glove (13) preferably on its back outer surface (17);
the device being such that when the electrically conductive palm cladding (16) is brought into contact with one of the said bodies (11) whilst the said electrical terminal (26; 29) is in contact with the other body (A; 32), the measuring device (12) is able to detect and to provide a signal indicative of the potential difference between the said bodies.

2. A device according to Claim 1, particularly for detecting the potential difference between an object (11) and the body (A) of a user,
characterised in that the said electrical terminal includes an electrode (26) which can be brought into contact with the body (A) of the user.

3. A device according to Claim 2, characterised in that the said electrode comprises an electrically conductive arm band (26) connected to the other input (19) of the said measuring device (12) and connectable to the wrist or to the arm (A) of the user adjacent the said glove (13).

4. A device according to Claim 1, particularly for detecting potential differences between two objects (11, 32)
characterised in that it includes a second glove (28) for the user's other hand, the said second glove (28) having at least one electrically conductive outer surface portion (29) preferably in its palm face, the said conductive portion (29) of the second glove (28) being connected to the said other input (19) of the measuring device (12) via an insulated flexible conductor (30).

5. A device according to Claim 4 characterised in that the said gloves (13, 28) are incorporated in a garment (31) in the form of a jacket or the like, intended to be worn by the user and in which the said flexible conductor (30) is incorporated.

6. A device according to any of the preceding claims, characterised in that the said measurement device (12) includes alarm means (22, 23) which can be activate when the measured potential difference exceeds a predetermined threshold.

7. A device according to Claim 6, characterised in that the said alarm means include devices (22) of optical type.

8. A device according to Claim 6 or Claim 7, characterised in that the said alarm means include devices (23) of acoustic type.

9. A device according to Claim 7, characterised in that the said alarm means comprise a plurality of illuminable indicators (22a, 22b, 22c) which can be selectively actuated when the measured potential difference lies in predetermined ranges of values.

10. A device according to any proceeding claim, characterised in that the measuring device (12) comprises
an input differential amplifier (38) with first and second inputs (18, 19) intended to be connected electrically to the first and second body (11; A, 32) respectively,
a two channel amplifier stage (39) connected to the output of the said differential amplifier (38), each channel (50, 51) being respectively disposed to amplify the output signal of the differential amplifier (38) when this signal (VA) is positive or negative respectively with respect to the ground terminal, and
a comparison and control circuit (40, 48) connected to the output of the said amplifier stage (39) and arranged selectively to control alarm indicators (22, 23) at its output in dependence on the value assumed by the signal provided at its input.
